# EUROPEAN PATENT APPLICATION

(11) **EP 2 680 336 A1**
(43) Date of publication of application: **01.01.2014**
(21) Application number: 12004754.3
(22) Date of filing: 25.06.2012
(51) Int. Cl.: H01L 51/00

(54) **Photoactive material having an imide based conjugated backbone**

(71) Applicant: Tata Steel Nederland Technology B.V., 1970 CA IJmuiden (NL)
(72) Inventor: Palaniswamy, Ganesan, 1970 CA Ijmuiden (NL); Hannour, Fouzia, 1970 CA IJMUIDEN (NL); Dingemans, Theodorus Jacobus, 2331 LZ LEIDEN (NL); Bouwer, Ricardo Klaas Maarten, 2611 CR DELFT (NL)
(74) Representative: Kruit, Jan

(57) **Abstract**

The invention relates to photoactive material suitable for use as a donor or acceptor in an organic photovoltaic cell, the photoactive material comprising a conjugated backbone comprising at least one chromophore and at least one imide group -OCNR1 CO-, wherein R1 is an organic group forming a conjugated bond with the imide group. This photoactive material can be used in organic solar cells, OLED's and charge transfer material in dye-sensitized solar cells. The invention also relates to a method of preparing this photoactive material, its use and a organic solar cell comprising this photoactive material.

## Description

The present invention relates to a photoactive material, e.g. for use in organic photovoltaic devices, a method of preparing such photoactive material, use thereof in a photovoltaic device and a photovoltaic device comprising this photoactive material.

Photovoltaic devices constructed of organic photoactive materials - hereinafter organic solar cells - have gained much scientific attention due to the promise of easy processing, light weight and potentially low cost. Many of these organic solar cells comprise photoactive material based on conjugated polymers as electron donor and hole conductor. Because polymer processing is well-developed, it is expected that these known roll-to-roll processing techniques like doctor-blading, spraying, printing and roll-coating can be applied in manufacturing organic solar cells, in particular large-area, inexpensive solar cells on flexible supports, which would open a tremendous number of possible applications. Interest in organic solar cells has further been increased due to the discovery of the so called heterojunction concept, which interest focuses inter alia at optimizing the interface between the donor and acceptor organic phases in a blend thereof, where excitons dissociate into electrons and holes and thus cause charge flow.

Traditionally, conjugated polymers such as MDMO-PPV, P3HT and the likes are used as donor phase in order to absorb light and generate and transfer excitons to the interface with the acceptor phase, where exciton dissociation occurs. For the acceptor phase fullerene, PCBM, CN-PPV and the likes are frequently used as exemplary materials.

One of the drawbacks of these known photoactive materials, whether donor or acceptor, is related to their complex procedure of synthesizing including purification in order to remove metal catalysts used in the synthesis, to obtain electronic grade starting materials. Stringent conditions are required both during preparation of the starting materials, as well as during production of the solar cells derived thereof. Moreover, it has appeared that these materials are sensitive to oxygen and water vapour. This sensitivity involves the risk of degradation and changes of morphology, especially at temperatures above room temperature, and thus a reduced efficiency and a limited lifetime of the photoactive material are likely to occur.

It is an object of the present invention to provide a photoactive material, whether donor or acceptor depending on the respective band gap, which does not have the above mentioned disadvantages of the known materials, or at least to a lesser extent.

In particular, it is an object of the present invention to provide a photoactive material, which can be prepared using a simple process

Another object of the present invention is to provide a photoactive material that shows an improved stability and/or fixed morphology during its entire service period.

According to the invention one or more of the above objects are achieved by a photoactive material suitable for use as a donor or acceptor in an organic photovoltaic cell, the photoactive material comprising a conjugated backbone comprising at least one chromophore and at least one imide group -OCNR1CO-, wherein R1 is an organic group forming a conjugated bond with the imide group. The photoactive material according to the invention comprises (poly)imide based single molecules or polymers. The photoactive material has a conjugated system, which comprises at least one chromophore for absorbing light, and at least one imide group. A further organic group is attached to the nitrogen atom of an imide moiety and forms a conjugated bond with the imide moiety. Depending on its counterpart and on their band gaps the photoactive material according to the invention can act as a donor or as an acceptor in solar cells. Photoactive material according to the invention having a (poly)imide based conjugated backbone also comprising a chromophore within its backbone is temperature and chemical resistant, and shows an improved tolerance towards oxygen and moisture compared to the state of the art materials. Generally, the photoactive material according to the invention possesses a fixed morphology, even at temperatures above ambient and an improved service life, because the photoactive material upon imidization and polymerization, if any, will not undergo additional chemical reactions or reorientation..

Here it is to be noted that imides such as naphthalene and perylene diimides (not covered by the present invention) have been used as photoactive materials in organic solar cells. In these cases, the molecules are imides of the chromophore itself and therefore it is not possible to change their band gaps without changing their original structure and properties or only to a very limited extent. The concept of the present invention allows to incorporate an appropriate chromophore depending on the band gap to be used, which gives the flexibility to change the desired properties. In this way, a molecule can be designed to be a donor as well as an acceptor.

The group R1 attached to the nitrogen atom of the imide group, contributes to the absorption of light, as well is considered a solubilising group for solubilising the photoactive material in the solvents typically used in the production of organic photovoltaic cells. Advantageously the group R1 comprises a solubilising moiety, preferably a straight or branched alkyl moiety. In a preferred embodiment of the photoactive material according to the invention the at least one chromophore is not attached directly to the at least one imide group in the conjugated backbone. More preferably an aryl group, such as a phenyl group, is present between the at least one chromophore and the at least one imide group. Advantageously the chromophore comprises an organic group comprising at least a heteroatom selected from Si, S, N and O. A preferred use of the photoactive material according to the invention concerns the photoactive layer of a solar cell, in particular in a blend with a counterpart, in a bulk heterojunction solar cells. Advantageously the photoactive material according to the invention functions as a donor. Known acceptor materials may be used as counterparts. Preferably the blend comprises different photoactive materials according to the invention, both as a donor and an acceptor.

Other advantageous applications of the photoactive material according to the invention are OLED and charge transport material in dye-sensitized solar cells.

The photoactive material according to the invention having a imide based conjugated backbone can be a molecule comprising at least one imide moiety in the conjugated system thereof. Preferably the photoactive material comprises at least two imide groups in the conjugated backbone. The number of imide bonds is not particularly limited.

In a preferred embodiment of socalled small molecules the photoactive material comprises compounds having the general formula R2-imide-Ar-L-Ar-imide-R3,
wherein
L is chromophore
Ar is a conjugated group, preferably aryl, such as phenyl
imide is imide
and R2 and R3 are organic groups bonded to the N atom of the imide and forming a conjugated bond with the respective imide group. Typically R2 and R3 are identical. Advantageously R2 and R3 comprise a solubilising group as explained above.

Typical examples of this type of photoactive material include

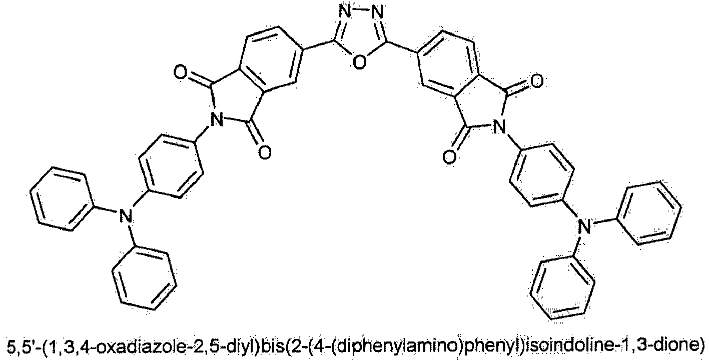

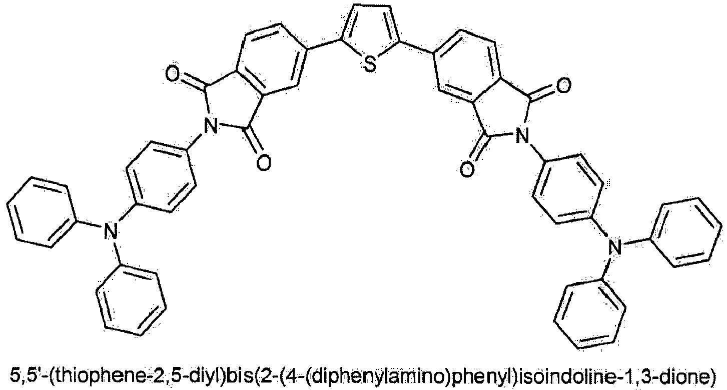

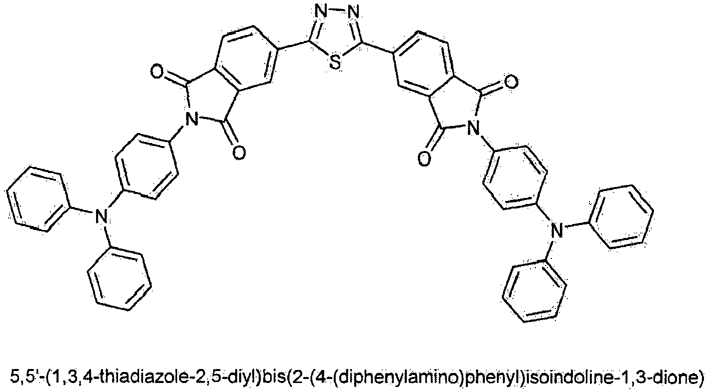

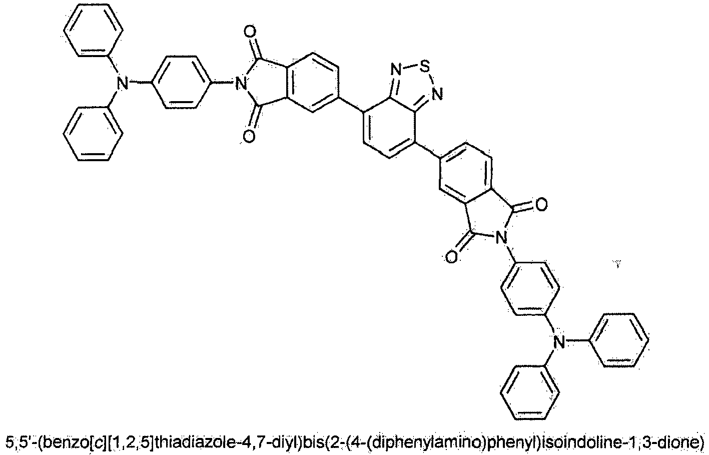

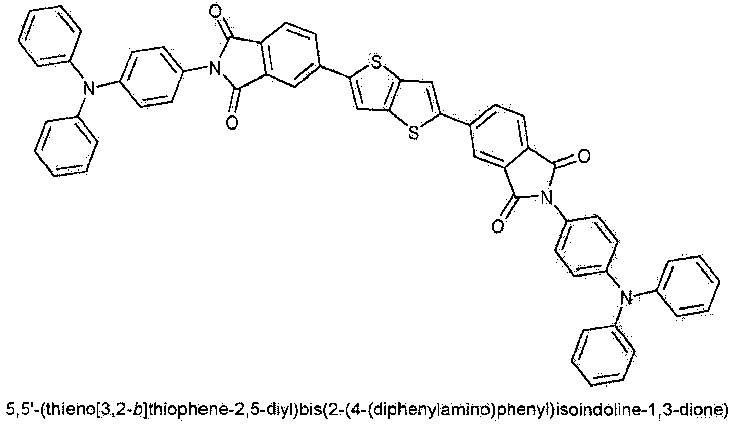

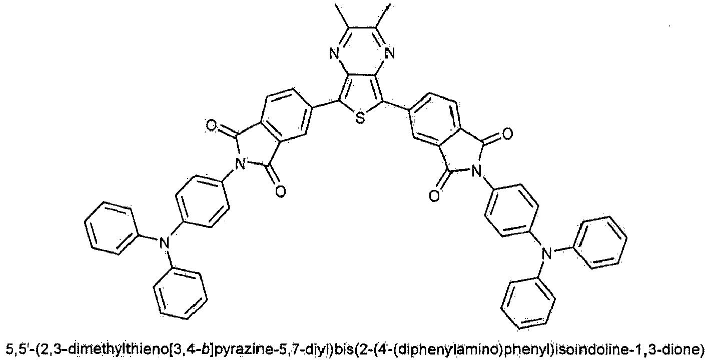

In a polymeric embodiment of the photoactive material of the invention, the photoactive material comprises polymers having repeating units (R4-imide-Ar-L-Ar-imide)n,
wherein
L is chromophore
   Ar is a conjugated group, preferably aryl, such as phenyl
   imide is imide
   R4 is an organic group bonded to the N atom of the imide forming a conjugated bond with the respective imide
   and n is the number of repeating units.

Advantageously R4 comprises a solubilising group as explained above.

Preferably the chromophore comprises a 5 membered organic ring group comprising 1-3 heteroatoms selected from Si, S, N and O.

Examples of the chromophores comprising at least one heteroatom include the compounds comprising one or two rings comprising a heteroatom shown below at the left.

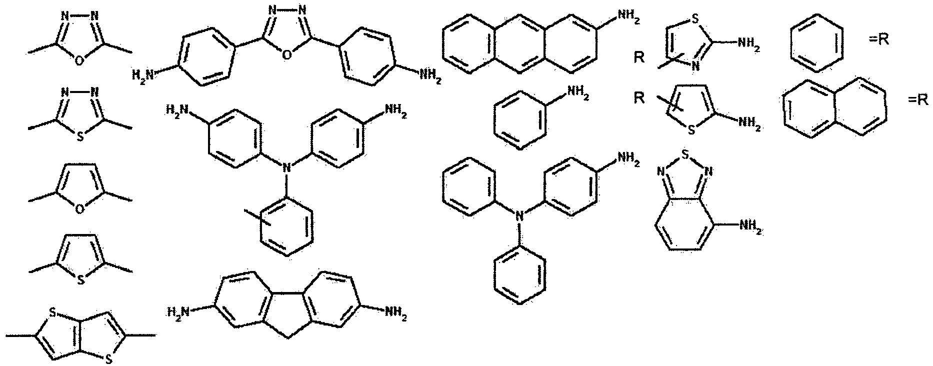

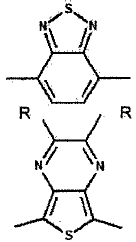

Regarding organic groups R1, R2, R3 and R4 they can be any group that forms a conjugated bond with the respective imide group. Examples include inter alia the aromatic amines illustrated above.

The invention also relates to a method of preparing a photoactive material suitable for use as a donor or acceptor in an organic photovoltaic cell, the photoactive material comprising a conjugated backbone comprising at least one chromophore and at least one imide group - OCNR1CO-, wherein R1 is an organic group forming a conjugated bond with the imide group, said method comprising
- an imidization reaction of an aromatic carboxylic acid anhydride comprising at least one chromophore with an amine R1-NH2 thereby obtaining a conjugated bond at the imide moiety thus formed.

The method according to the invention comprises an imidization reaction as a simple preparation step, wherein an aromatic carboxylic acid anhydride comprising at least one chromophore and an amine R1-NH2, preferably an aromatic amine, are reacted in order to form an imide group, the group R1 further taking part in the conjugated system.

In a preferred embodiment of manufacturing a polymeric photoactive material the aromatic anhydride is a dianhydride, which is allowed to react with a diamine.

In a further aspect the invention relates to the use of a photoactive material according to the invention as defined above or produced according to the invention as defined above in an organic solar cell.

The invention also relates to a solar cell comprising at least a substrate, a cathode, a hole transport layer, a bulk heterojunction photoactive layer, an electron transport layer and an anode, wherein the bulk heterojunction photoactive layer comprises a photoactive material according to the invention or photoactive material prepared according to the invention.

The embodiments discussed above with respect to the photoactive material are similarly applicable to the preparation method, use and solar cell according to the invention.

The invention is further illustrated by the attached drawing and examples

In the drawing
Fig. 1 shows an imide moiety.
Fig. 2 and 3 show synthetic routes, which are illustrative for preparing a imide backbone structure of the photoactive layer according to the invention;
Fig. 4 shows examples of small molecular (oligomeric) and polymeric imides;
Fig. 5 shows a synthesis example according to the invention; and
Fig. 6 shows an embodiment of a solar cell according to the invention.
Fig. 7 shows the UV-Vis spectrum of the small molecule compound of Example 2 and in combination with PCBM.
Fig. 8 shows the results of cyclic voltammetry of the small molecule compound of Example 2.

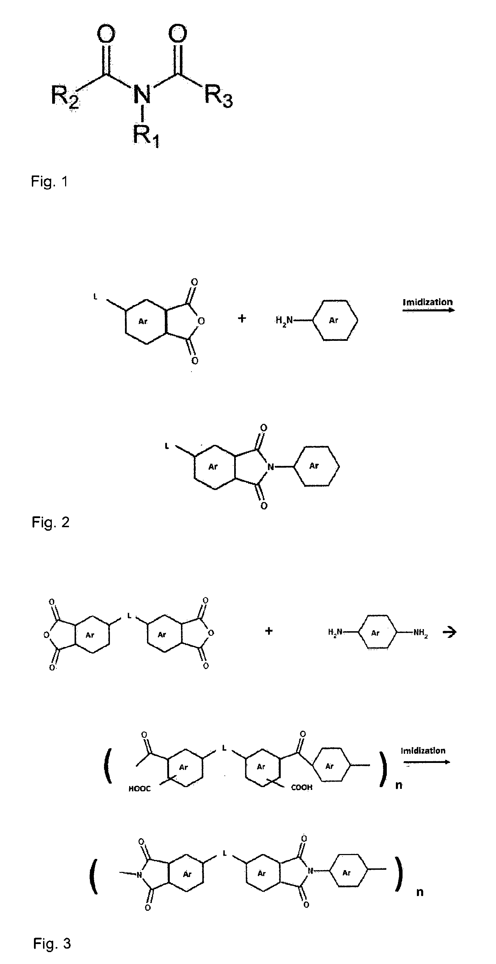

Fig. 1 shows an imide moiety, wherein the R1 group is attached to the N atom of the imide. In Fig. 2 a generic route is illustrated for a condensation reaction starting from an aromatic monoamine and an aromatic anhydride, the latter comprising a 5 membered hetero ring as chromophore. In particular, 1,3-dihydro-2-benzofuran-1,3-dione is allowed to react with aniline thereby producing the aromatic imide product 2-phenyl-2,3-dihydro-1H-isoindole-1,3-dione.

Fig. 3 shows a generic route for preparing a photoactive material according to the invention starting from a diamine and a dianhydride. In particular, an aromatic dianhydride comprising a 5 membered hetero ring as chromophore is allowed to react with an aromatic diamine, forming a (poly)amic acid intermediate product, which is directly converted by thermal or chemical imidization into the polyimide backbone structure.

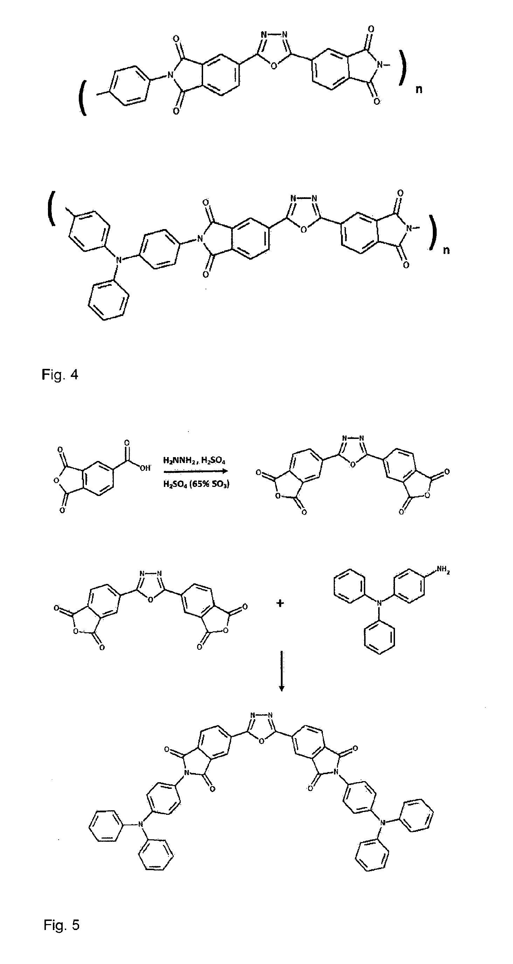

Fig. 4 shows 2 examples of imide backbones of small molecules and polymeric imides respectively.

Fig. 5 shows a specific example, wherein 1,3-dixo-1,3-dihydro-2-benzofuran-5-carboxylic acid is reacted with ethylene diamine in the presence of sulphuric acid (66% SO3) yielding a dianhydride, which is allowed to react with aniline-diphenylamine in glacial acetic acid using reflux.

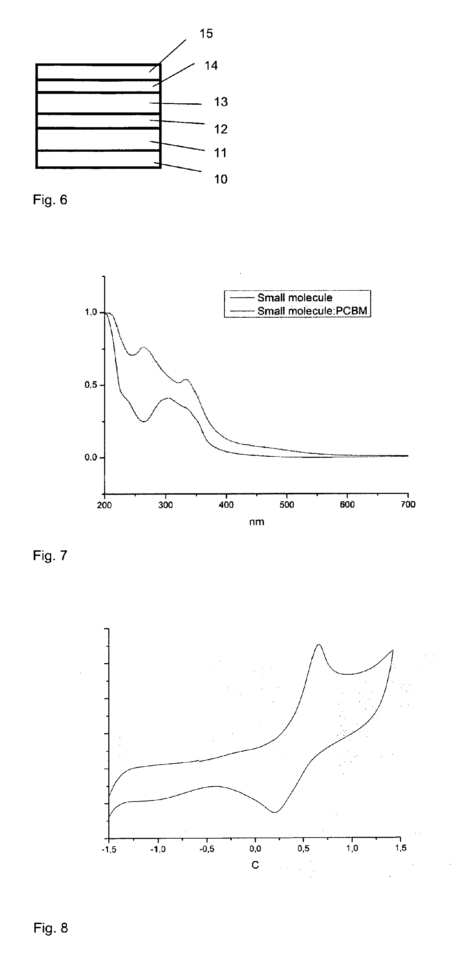

Fig. 6 illustrates a bulk heterojunction organic solar cell, wherein a substrate e.g. a transparent one from glass or plastic, or an (electrically isolated) thin metal foil, made e.g. from steel or aluminium, is indicated by reference numeral 10 and bears an electrode layer 11. On top of this electrode layer a charge transport layer 12 is arranged. An active layer 13 comprises a photoactive material according to the invention e.g. a donor and its counterpart (an acceptor like fullerene and its derivatives) in a blend. On top thereof a further charge transport layer 14 is positioned, as well as a transparent electrode layer 15.

The following examples illustrate a preparation process according to the invention.

### EXAMPLE 1. Synthesis of 5,5'-(1,3,4-oxadiazole-2,5-diyl)bis(isobenzofuran-1,3-dione).

A 1 L threeneck flask equipped with stirring bar, condenser and N₂ inlet was charged with 77 g 1,3-dioxo-1,3-dihydroisobenzofuran-5-carboxylic acid (401 mmol) and 200 mL fuming sulfuric acid (65% free SO₃). The resulting suspension was heated to 75 °C and stirred until all 1,3-dioxo-1,3-dihydroisobenzofuran-5-carboxylic acid was dissolved. Hydrazine sulfate salt ( 23.7 g, 182 mmol) was added in portions and the reaction mixture was heated to 90 °C and stirred at this temperature for 4 hours.

The reaction mixture was poured onto crushed ice and the white precipitate was filtered off. The sticky white solids were washed by stirring in water until the pH was neutral. Residual water was removed by azeotropic distillation with 300 mL toluene and further drying overnight in a vacuum oven at 50 °C yielding the crude product as 61 g white solids. 30 g of the crude products were stirred in 200 mL acetic anhydride at 90 °C for 3 hours. The solids were filtered off and washed with hexane (3 x 100 mL) and dried overnight in a vacuum oven at 50 °C. Yielding 21 g of the title compound as white solid (58mmol, 29%).

### EXAMPLE 2. Synthesis of 5,5'-(1,3,4-oxadiazole-2,5-diyl)bis(2-(4-(diphenylamino)phenyl)isoindoline-1,3-dione).

A 250 mL threeneck flask equipped with stirring bar, condenser and N₂ inlet was charged with 10 g 5,5'-(1,3,4-oxadiazole-2,5-diyl)bis(isobenzofuran-1,3-dione) (27.6 mmol), 15.8 g of N1,N1-diphenylbenzene-1,4-diamine (2.2 eq.) and 100 mL glacial acetic acid. The resulting suspension was heated to reflux temperature and stirred at this temperature for 8 hours. The reaction mixture was poured onto crushed ice and the orange precipitate was filtered off. The solids were washed with water (2x 100 mL) and hexane (2x 100 mL). The filtrate was dissolved in hot chloroform and filtered. The solution was allowed to cool down to room temperature and the precipitated orange solid was filtered off. The solids were dried overnight in a vacuum oven at 60 °C. Yielding 20.8 g of the title compound as orange solid (24.6 mmol, 89%).
%). ¹H NMR (300 MHz, CDCl₃) δ ppm 8.90 (m, 2H), 8.83 (m, 2H),8.35 (m, 2H), 7.48 (m, 12H), 7.36 (m, 12H), 7.27 (m, 4H); ¹³C NMR (100 MHz, CDCl₃) δ ppm 166.28, 166.18, 163.91, 147.93, 147.22, 134.28, 132.91, 132.84, 129.41, 128.90, 127.13, 125.01, 124.63, 124.52, 123.58, 122.77 and 121.98.

### EXAMPLE 3. Manufacturing solar cell

The small molecule of Example 2 and fullerene derivatives were dissolved in a 1:1 weight ratio in the respective solvents as indicated in the below Table 1 and the solution was stirred at 60 °C or 100 °C as indicated. The photoactive layers were spin-cast in air on clean glass substrates pre-patterned with indium tin oxide and a 60 nm thick film of poly(3,4-ethylenedioxythiophene)/poly(styrenesulfonic acid). The devices were finished by thermal evaporation of a LiF(1 nm)/Al(100 nm) cathode at 1 × 10⁻⁶ mbar. Electrical measurements were conducted in an N₂ controlled atmosphere in dark and under illumination of a Steuernagel SolarConstant 1200 metal halide lamp, which was set to 1 Sun intensity using a silicon reference cell and correcting for spectral mismatch.

**Table 1.**

| | | | | | | |
|---|---|---|---|---|---|---|
| | | | | | | |
| ODCB | 60 | [60] | 0.63 | 1.03 | 0.27 | 0.17 |
| ODCB | 100 | [70] | 0.64 | 0.67 | 0.26 | 0.11 |
| CB | 100 | [60] | 0.13 | 1.07 | 0.26 | 0.04 |
| CB | 100 | [70] | 0.59 | 0.57 | 0.26 | 0.09 |
| CHCl₃ | 60 | [60] | 0.10 | 1.05 | 0.25 | 0.03 |
| CHCl₃ | 60 | [70] | 0.30 | 0.89 | 0.25 | 0.07 |

Fig. 7 shows the UV-Vis spectrum of the title compound of Example 2 (lower line) and the title compound:PCBM in 1:1 ratio (upper line) both recorded in the film spincoated from CHCl₃.

Fig. 8 is a diagram showing the results of cyclic voltammetry performed with the title compound of Example 2. An oxidation potential of 0.44 V relative to Fc/Fc⁺ was found.

## Claims

1. Photoactive material suitable for use as a donor or acceptor in an organic photovoltaic cell, the photoactive material comprising a conjugated backbone comprising at least one chromophore and at least one imide group -OCNR1CO-, wherein R1 is an organic group forming a conjugated bond with the imide group.

2. Photoactive material according to claim 1, wherein R1 comprises a solubilising moiety.

3. Photoactive material according to claim 2, wherein the solubilising moiety comprises a straight or branched alkyl moiety.

4. Photoactive material according to any one of the preceding claims, wherein in the conjugated backbone the at least one chromophore is not attached directly to the at least one imide group.

5. Photoactive material according to any one of the preceding claims, wherein the conjugated backbone comprises an aryl moiety between the at least one chromophore and the at least one imide group.

6. Photoactive material according to any one of the preceding claims, wherein the chromophore comprises an organic group comprising at least one heteroatom selected from Si, S, N and O.

7. Photoactive material according to any one of the preceding claims, wherein the photoactive material comprises compounds having the general formula R2-imide-Ar-L-Ar-imide-R3, wherein
L is chromophore
Ar is a conjugated group, preferably aryl
imide is imide
R2 and R3 are organic groups, bonded to the N atom of the imide and forming a conjugated bond with the respective imide.

8. Photoactive material according to any one of the preceding claims 1-6, wherein the photoactive material comprises polymers having repeating units (R4-imide-Ar-L-Ar-imide)n,
wherein
L is chromophore
Ar is a conjugated group, preferably aryl
imide is imide
R4 is an organic group bonded to the N atom of the imide and forming a conjugated bond with the respective imide
and n is the number of repeating units.

9. Photoactive material according to any one of the preceding claims, wherein the chromophore comprises a 5 membered organic ring group comprising 1-3 heteroatoms selected from Si, S, N and O.

10. Photoactive material according to any one of the preceding claims, wherein the chromophore is selected from the group comprising

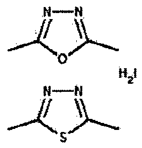

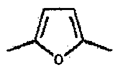

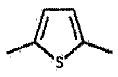

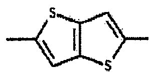

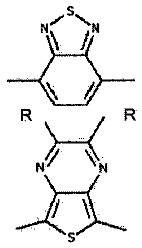

11. Method of preparing a photoactive material suitable for use as a donor or acceptor in an organic photovoltaic cell, the photoactive material comprising a conjugated backbone comprising at least one chromophore and at least one imide group - OCNR1CO-, wherein R1 is an organic group forming a conjugated bond with the imide group comprising
- an imidization reaction of an aromatic carboxylic acid anhydride comprising at least one chromophore with an amine R1-NH2 thereby obtaining a conjugated bond at the imide moiety thus formed.

12. Method according to claim 11, wherein the aromatic carboxylic acid anhydride is a dianhydride.

13. Method according to claim 10 or claim 11, wherein the amine is an aromatic amine, preferably an aromatic diamine.

14. Use of a photoactive material according to one of the preceding claims 1-10 or prepared according to one of claims 11-13 in an organic photovoltaic cell, in OLED's and as a charge carrier in dye-sensitized solar cells.

15. Solar cell, comprising at least a substrate, a cathode, a hole conductive layer, a bulk heterojunction photoactive layer, a electron conductive layer and an anode, wherein the bulk heterojunction photoactive layer comprises a photoactive material according to one of the preceding claims 1-10 or prepared according to one of claims 11-13.
